(19)

Europäisches Patentamt
European Patent Office
Office européen des brevets

(11) **EP 2 077 145 A1**

(12) **EUROPEAN PATENT APPLICATION**

(43) Date of publication:
**08.07.2009 Bulletin 2009/28**

(51) Int Cl.:
**B01D 46/00** (2006.01)   **B01D 46/44** (2006.01)
**G06F 1/20** (2006.01)   **H05K 7/20** (2006.01)

(21) Application number: **08000181.1**

(22) Date of filing: **07.01.2008**

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(71) Applicant: **Nokia Siemens Networks Oy**
**02610 Espoo (FI)**

(72) Inventor: **Mäkipää, Olli**
**00520 Helsinki, (FI)**

(74) Representative: **Bruglachner, Thomas E.**
**Nokia Siemens Network GmbH & Co. KG**
**Patentabteilung**
**Postfach 80 17 60**
**81541 München (DE)**

(54) **Method, module and computer program product for monitoring a particle filter device**

(57)    A method for monitoring a particle filter device (30, 52) is described, comprising:
- filtering a fluid,
- using the fluid for cooling,
- detecting (122) at least one temperature value (Ta) of the fluid after the cooling, and
- monitoring (124) the filtering using the at least one temperature value (Ta).

FIG 1

**Description**

The invention relates to a method for monitoring a particle filter device and to a corresponding module and computer program product. The method may comprise:

-    filtering a fluid,
-    using the fluid for cooling, and
-    monitoring the filtering.

Some customer specifications (NEBS, Network Equipment Building System) require a cooling air filter to be equipped in the network element to prevent dust and other small particles penetrating the network element. The air filter traps the small particles from the cooling air flow of the network element and thus will clog after a certain operating period.

Because changing or cleaning of the air filter requires the attendance of a technician, it would be beneficial that especially in the remote sites the change interval could be optimised: too frequent service causes cost and too rare service causes thermal risks to the network element. For that purpose there should be a supervision method and warning for the filter clog.

The clog could be detected by measuring air flow or pressure but this would require an extra sensor or extra sensors in the network element and might cause extra air flow resistance and thus decrease cooling.

The network element may be a switch, a router or some other network device. But the invention is not restricted to these applications. Therefore, it is possible to use different kinds of fluids, for instance liquid fluids or gaseous fluids.

There is a need to provide a simple method and a module for monitoring a particle filter device which especially is simple in construction and reliable in operation.

This need is accomplished by the subject of the independent claims. The subclaims refer to specific embodiments of the present invention.

There may be the following features in addition to the features mentioned at the beginning:

-    detecting at least one temperature value of the fluid after the cooling,
-    monitoring the filtering using the at least one temperature value.

The principle here is to use a temperature value for monitoring the filter device. In some cases only one temperature value may be used. However, in other cases a plurality of temperature values may be used as described below in more detail.

The at least one temperature value may be a digital value or an analogue one, for instance a voltage value. The method may be used to generate the clog warning of an air filter based on the temperature in the fluid flow, for instance in the air flow input and the air flow output of a network element. Temperature sensors may be necessary in many devices for other purposes. Therefore, there may be no extra hardware required for monitoring the particle filter device. In addition, it may be possible to adjust the parameters for the measurement automatically to fit in the application in each case. This will be described in more detail below.

There may be provided a module for housing electronics, comprising:

-    a casing,
-    at least one air inlet opening in the casing,
-    at least one air outlet opening in the casing,
-    an air filter device for filtering air that comes through at least one of the inlet opening,
-    a monitoring unit that monitors the function of the filter device and that is arranged within the module or outside of the module,
-    at least one temperature sensor that is connected to the monitoring unit.

Moreover, there is provided a computer program product for performing the above mentioned method steps.

According to an embodiment of the method there are the following features:

-    detecting at least one first temperature of the fluid before the cooling,
-    the at least one temperature value detected after the cooling being at least one second temperature value,
-    using the first temperature value and the second temperature value for the monitoring.

It is possible to reduce the influence of the temperature of the environment by using the first temperature value and the second temperature value. Therefore, it is possible to calculate a temperature difference from the first temperature value and the second temperature value that is almost independent from the environmental temperature.

An average temperature difference may be used for the monitoring during a measurement period. It is possible to reduce the influence of the environmental temperature and the influence of temperature changes, for instance effected by changing power consumption of an electronic device, by using an average temperature value or temperature difference.

The measurement period may be between twelve hours and two days or ten days. The preferred value is one day. It may be assumed, that there are similar temperature profiles each day. However, it is possible to choose a longer period, for instance to reduce the influence of load reduction at weekends.

The detection of the first temperature value and of the second temperature value may each be repeated more than hundred times or more than thousand times during the measurement period. Other repeating values are possible as well. Therefore, it is possible to detect the temperature steadily within a day, for instance. This embodiment may be used if it is not possible to switch off a device because the device is required to operate everyday. This is a typical situation in telecommunications devices, for instance. Alternatively, the same method may be used also for a device that is periodically switched off or that may be switched off, if the measurement is done when the device is switched on.

There may be the following features:

- determining a first average temperature difference during a first measurement period,
- determining a second average temperature difference during a second measurement period,
- using the first average temperature difference and using the second average temperature difference to verify the length of the measurement period or to decide to change the length of the measurement period.

In this way, it is possible, to adjust the period automatically for different systems. If an appropriate measurement period length is found, this length may be used for a longer time. New parameter adjustment may be necessary, for instance, if a new filter device is used instead of an old filter device.

There may be the following features:

- comparing the average temperature difference with at least one threshold value,
- creating an error signal if the at least one threshold value is not met.

The threshold value is a further parameter that may be predefined or that may be automatically adjusted. If only one threshold value is used it is possible to compare this threshold value with the average temperature difference.

An error signal may be used to trigger an inspection of a filtering device that is used for the filtering. A control lamp may be switched on or an email may be created that is sent to an operator.

The filtering may comprise filtering of air in a shelf comprising electronics. The shelf may be part of a rack that comprises a telecommunications system. It is especially important to monitor filter devices in telecommunications systems to prevent over heating of costly electronic equipment.

There may be:

- a first temperature sensor that is electrically connected to a first input of the monitoring unit,
- a second temperature sensor that is electrically connected to a second input of the monitoring unit.

Using two temperature sensors enables to reduce the influence of the environmental temperature if a temperature difference is calculated from the values created by the temperature sensors.

The module may comprise at least one fan for creating an air flow between the air inlet opening and the outlet opening. The fan may be driven by an electrical motor. Using a fan enables forced cooling. Alternatively it is possible to use the invention for unforced cooling.

The module may comprise a back plane having slots for a plurality of electronic circuit boards. The back plane may electrically connect the electronic circuit boards that are also named electronic circuit blades.

The module may comprise units that are necessary to perform the inventive method or embodiments thereof. Thus the technical effects mentioned above also apply to the embodiments of the module.

The foregoing has outlined rather broadly the features of the technical advantages of the embodiments of the present invention in order that the detail description of the invention that follows may be better understood. Additional features and advantages of embodiments of the invention will be described hereinafter. It should be appreciated by those skilled in the art that the conception and specific embodiments disclosed may be readily utilised for a basis of modifying or designing other structures or processes for carrying out the same purposes of the present invention. It should also be realised by those skilled in the art that such equivalent constructions do not depart from the spirit and scope of the invention as set forth in the appended claims.

For a more complete understanding of the present invention and the advantages thereof, reference is now made to the following description taken in conjunction with the accompanying drawings, in which:

Figure 1    illustrates a cross section through a shelf module,
Figure 2    illustrates an arrangement for cooling or heating,
Figure 3    illustrates a flow chart of a method for monitoring the filter device.

The making and using of the presently preferred embodiments are discusses in details below. Moreover, same reference signs refer to the same technical features if not stated otherwise. As far as "may" is used in this application it means the possibility of doing so as well as actual technical implementation.

The present invention will be described with regard to preferred embodiments to specific context namely telecommunications equipment. The invention may also be applied, however, to other equipments.

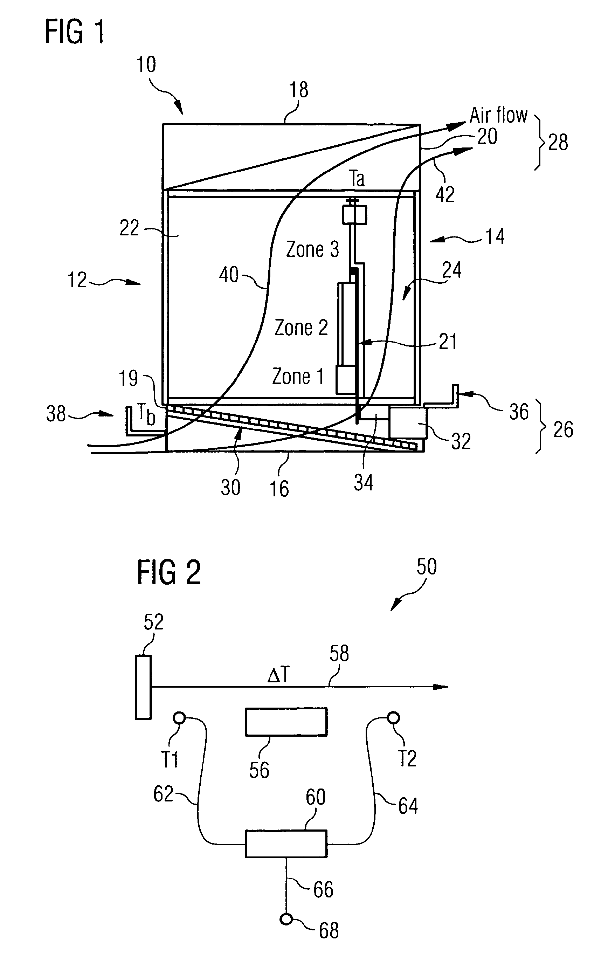

Figure 1 illustrates a cross section through a module 10, which may be part of a rack that comprises telecommunications equipment. The module 10 is a box, which forms a casing. The box has:

- front plate 12:

- rear plate 14,
- bottom plate 16,
- top plate 18.

Side plates of the module 10 are not shown in Figure 1 but are arranged in parallel to the drawing plane of Figure 1. An inlet opening 19 is arranged below the front plate 12 or in the lower portion of the front plate 12. An outlet opening 20 is arranged above the rear plate 14 or in an upper portion of the upper plate 14. The module 10 comprises a back plane 21 that is arranged in parallel to the front plate 12 and to the rear plate 14. The back plane 21 divides the module 10 in a front part 22 and in a rear part 24. Front part 22 is larger than rear part 24 in the embodiment shown in Figure 1.

Furthermore, there is a lower part 26 below front part 22 and below rear part 24. An upper part 28 of module 10 is located above front part 22 and above rear part 24.

The lower part 26 comprises an air filter 30, for instance a dense filter mesh or a filter fabric. The upper part 28 may comprise a fan unit, not shown, to produce forced air flow 40 and air flow 42 which will be described in more detail below. Alternatively, the positions of the filter and the fan or fans may be vice versa resulting in an opposite direction of air flows 40 and 42. Module 10 comprises power entry modules 32 that are arranged in lower part 26 below rear part 24. Power entry modules 32 are used to connect power cables to module 10.

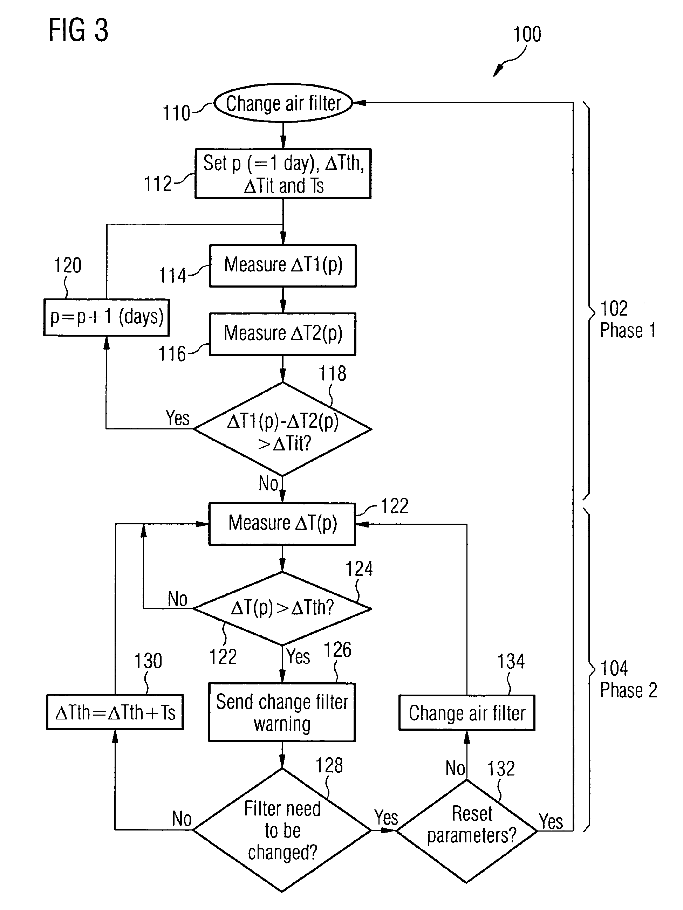

A shelf manager controller 34 (ShMC) is also arranged in lower part 26 below rear part 24. Shelf manager controller 34 interacts with a system manager device that may be inserted in one of the slots of the back plane 21. The system manager device may be inserted in module 10 or in another module of the same rack. Alternatively, it is possible to place the shelf manager controller on the same board as the system manager device. Shelf manager controller 34 or the system manager itself may perform the method for monitoring filter 30 as explained below with reference to Figure 3.

Figure 1 shows an optional rear cable tray 36 and an optional front cable tray 38. A temperature sensor Ta is arranged above back plane 21 in upper part 28. A temperature sensor Tb is arranged near inlet opening 19 in lower part 26.

Air flow 40 is through inlet opening 19, through filter device 30, through front part 22 and then through outlet opening 20. Air flow 42 is from inlet opening 19 through filter device 30, through rear part 24 and then through outlet opening 20. Airflows 40 and 42 are used for cooling electronic equipment arranged on circuit boards that are connected to back plane 21.

Temperature sensors Ta and Tb may also be arranged at other positions along airflows 40 and 42. Furthermore, it is possible to use more than one temperature sensor Ta, Tb respectively for redundancy reasons or for other reasons.

Figure 2 shows an arrangement 50 for cooling or heating. Arrangement 50 may correspond to module 10 or to another arrangement.

Arrangement 50 contains a filter device 52 that filters incoming fluid flow 58. Fluid flow 58 is used for cooling device 56 thereby creating temperature difference in fluid flow 58. The fluid of fluid flow 58 may be a liquid or a gas, for instance air.

Arrangement 50 comprises a temperature sensor T1 to detect or to measure the temperature of the fluid flow 58 before temperature adjustment. A temperature sensor T2 is used to detect or to measure the temperature of fluid flow 58 after cooling.

Temperature sensors T1 and T2 are electrically connected to a monitoring unit 60 by connections 62 and 64 respectively, for instance by electrical conductive lines. Monitoring unit 60 monitors the cloging of the filter device 52 based on the temperatures detected by temperature sensors T1 and T2 as explained in more detail below with reference to Figure 3. Furthermore, a connection 66 is from monitor unit 60 to an output 68. An output signal of output 68 indicates that the filter device 52 has to be cleaned or renewed to prevent unreliable temperature adjustment.

Figure 3 illustrates a flow chart 100 of a method for monitoring air filter device, for instance filter 30 shown in Figure 1 or filter device 52 shown in Figure 2. Flow chart 100 comprises two phases 102 and 104. Phase 102 is also named as phase 1 and is used to adjust a measurement period p. Phase 104 is also named as phase 2 and is used for monitoring the filter 30.

The method starts with step 110 by changing the air filter 30, i.e., a new air filter is inserted in module 10. In a step 112 that follows step 110 the measurement period p is set to a default value, for instance to one day. In the example, p is set to 1440, i.e., to the number of minutes of one day. Furthermore, an average temperature difference $\Delta Tth$ is predefined, for instance empirically. An average temperature difference integration value $\Delta Tit$ is defined to give a value for the maximum deviation of two successive average temperature difference values. A temperature step value $Ts$ is pre-defined that is used to raise the average temperature difference threshold $\Delta Tth$. $\Delta Tit$ and $\Delta Tth$ may be selected empirically too, for instance.

In a step 114, an average temperature difference $\Delta T1(p)$ is detected or measured according to the following formula:

$$\Delta T(p) \; = \; \mathrm{Sum}(t{=}1, \; p, \; Ta(t) \; - \; Tb(t))/p,$$

where p is the measurement period, t are time points and "sum" means a summation for t = 1 to p of the respective differences Ta (t) - Tb(t).

After determining $\Delta T1(p)$ an average temperature difference $\Delta T2(p)$ is determined in a step 116 according to the same formula as used in step 114 but for a different measurement period p, for instance for the next day.

After performing step 116 a step 118 is performed to determine, whether the difference of the average temperature difference $\Delta T1(p)$ and $\Delta T2(p)$ is greater than the average temperature difference integration value $\Delta Tit$. It is of course possible to regard only absolute values in step 118. If the difference $\Delta T1(p)$ and $\Delta T2(p)$ is greater than $\Delta Tit$ then a step 120 follows immediately after step 118.

In step 120 the measurement period p is increased, for instance by one day. After step 120 steps 114, 116 and 118 are repeated. Thus, the method is in a loop of steps 114 to 120. This loop 114 to 120 is left in step 118 only if the difference of $\Delta T1(p)$ and $\Delta T2(p)$ is smaller than the average temperature integration value $\Delta Tit$ or equal. In this case a step 122 follows immediately after step 118 and phase 102 or phase 1 is left.

Step 122 is the first step of phase 104 or phase 2. In step 122 again an average temperature difference $\Delta T(p)$ is measured according to the formula mentioned for step 114 above. The measurement of step 122 may refer to a measurement period p that is different from measurement periods p used in steps 114 and 116, for instance the third day may be regarded.

After step 122 a step 124 is performed, to determine whether the average temperature difference $\Delta T(p)$ determined in step 122 is greater than average temperature difference threshold $\Delta Tth$ that was predefined in step 112. If this is not the case the method goes back to step 122, i.e., average temperature difference threshold $\Delta Tth$ is determined for the following period p. The method is now in a loop containing the steps 122 and 124. This loop 122, 124 is left in step 124 only if it is determined that the current average temperature difference $\Delta T(p)$ determined in step 122 is greater than the average temperature threshold $\Delta Tth$. In this case a step 126 follows immediately after step 124.

In step 126 a filter warning message is created and sent to an operator. After step 126 a step 128 is performed. In step 128 a service person checks whether the filter device 30 is dirty. If it is found that the filter device 30 has not to be changed then step 130 follows immediately after step 128. In step 130 the average temperature difference threshold $\Delta Tth$ is increased by the step temperature $Ts$ that was predefined in step 112. Then the method continues with step 122.

The method is now in a loop containing the steps 122 to 130. This loop 122 to 130 is left in step 128 only if the service person determines that filter device 30 has to be changed, i.e., a new filter device 30 is used or the old filter device 30 is cleaned. If this is the case, step 132 follows immediately after step 128.

In step 132 the service person checks if it is necessary to reset parameters predefined in step 112. If this is not the case the filter device 30, 52 is cleaned or changed in step 134. Then the method continues with step 122.

The method is now in a loop containing the steps 122 to 134. This loop 122 to 134 is left in step 132 only if the service person determines that parameters have to be reset. In this case step 110 follows immediately after step 132, i.e., the method starts again.

Figure 3 illustrates a flowchart 100 of a method and computer program product according to the present invention. It will be understood that each block or step of the flowchart and combinations of blocks in the flowchart, can be implemented by computer program instructions or by hardware without using a program. These computer program instructions may be loaded onto a computer or another programmable apparatus to produce a machine, such that the instructions which are executed on the computer or other programmable apparatus create means for implementing the function specified in the blocks or steps of the flowchart. These computer program instructions may also be stored in a computer-readable memory, e.g., DVD, CD, diskette, RAM, ROM, that can direct a computer or other programmable apparatus to function in a particular manner. Moreover, these computer program instructions may be downloaded, for instance in a telecommunications network, to cause operational steps to be performed on the computer or other programmable apparatus to produce a computer implemented process such that the instructions which execute on the computer or other programmable apparatus provide steps for implementing the functions specified in the blocks or steps of the flowchart.

Moreover, the sequence of steps shown in flow chart 100 can be modified, i.e., additional steps can be inserted or some of the steps may be optional.

With other words, the example was described in ATCA (Advanced Telecommunications Computing Architecture) environment. But there are no restrictions to expand it to other environments having the required sensors and filters, however.

The algorithm is based on the measurement of temperature difference between the temperature of airflow input (Tb in Figure 1) and the temperature of airflow output (Ta in Figure 1). In the first phase 1 of the algorithm the required measurement period p is defined. This is basically based on the fact that a variation of the temperature caused by the air filter congestion is much slower than variation of other reasons like traffic load variation of the network element. First, the measurement period p is set, for instance, to one day (in number of minutes) which is expected to filter out other reasons of temperature variations than air filter congestion, i.e., variation of power consumption of network element. Then $\Delta T(p)$ is measured as an average temperature difference during the measurement period. Measurement frequency for average value can be, for instance, one minute. This means that

$$\Delta T(p) = Sum(t=1, p, Ta(t) - Tb(t))/p,$$

where p is the measurement time in the number of minutes (1440 in the case of one day). This measurement is repeated, for instance, twice ($\Delta T1$ and $\Delta T2$) and the results are compared to each other. If the results are close enough, i.e., inside integration time threshold value $\Delta Tit$, then the measurement period p is considered being long enough to filter out other variations than the filter clog. If the results are too far from each other, the measurement period is increased by one unit, for instance by one day, and initial measurements are repeated.

After defining the measurement period p, the filter supervision measurements are started, i.e., phase 2. Then $\Delta T(p)$ is simply measured and compared to the preset threshold value $\Delta Tth$. This measurement is repeated until $\Delta Tth$ is exceeded. When this happens "clog warning of air filter" is sent to the network element operator. After the technician has checked the filter, the technician will either change the filter (if required) or confirm the false alarm which causes the threshold temperature $\Delta Tth$ to be increased by preset value Ts.

In addition, one should notice that the temperature difference $\Delta T$ does not directly depend on the absolute temperature Tb but the $\Delta T$ remains constant while the ambient temperature of the site varies.

When the filter is changed the technician can decide whether she/he keeps the adjusted parameters ($\Delta Tth$ and p) or restarts the process.

Other issues to be taken into account when the algorithm is implemented are:

- The fan speed will increase which in turn will decrease $\Delta T$, when site temperature raises enough. This should be taken into account by measuring the $\Delta T$ only when the fan speed setting has allowed normal value(s). An example for temperature raise is a fault in the air condition device of the room in which the system is located.
- Threshold temperature $\Delta Tth$ shall be lower than the threshold value for higher (exceptional) fan speed in normal room temperature.
- Ts, $\Delta Tth$ and $\Delta Tit$ will be defined based on the measurements.
- The temperature sensors Ta, Tb should be equipped in the location where the temperature can be assumed to be (relatively) independent of network element configurations. For instance, in ATCA (Advanced Telecommunications Computing Architecture) environment this could be over Hub slots or in Hub slots.
- To increase the reliability of the measurement, several sensors can be used in the input flow and output flow, respectively, for instance for redundancy reasons or to determine mean values.

Although embodiments of the present invention and their advantages have been described in detail, it should be understood that various changes, substitutions and alterations can be made therein without departing from the spirit and scope of the invention as defined by the appended claims. For example, it will be readily understood by those skilled in the art that many of the features, functions, processes and methods described herein may be varied while remaining within the scope of the present invention. Moreover the scope of the present application is not intended to be limited to the particular embodiments of the system, process, manufacture, method or steps described in the specification. As one of ordinary skill in the art will readily appreciate from the disclosure of the present invention systems, processes, manufactures, methods or steps presently existing or to be developed later, that perform substantially the same function or achieve substantially the same result as the corresponding embodiments described herein may be utilised according to the present invention. Accordingly the appended claims are intended to include within their scope such systems, processes, methods or steps.

List of Reference signs

| | |
|---|---|
| 10 | module |
| 12 | front plate |
| 14 | rear plate |
| 16 | bottom plate |
| 18 | top plate |
| 19 | inlet opening |
| 20 | outlet opening |
| 21 | back plane |
| 22 | front part |
| 24 | rear part |
| 26 | lower part |
| 28 | upper part |
| 30 | filter device |
| 32 | power entry modules |
| 34 | shelf manager controller (ShMC) |
| 36 | rear cable tray |
| 38 | front cable tray |
| 40, 42 | airflow |
| Ta | temperature sensor |
| Tb | temperature senor |
| 50 | arrangement for cooling or heating |
| 52 | filter device |
| 56 | cooled or heated device |
| 58 | fluid flow |
| T1, T2 | temperature sensor |
| 60 | monitoring unit |
| 62 to | 66 connection |
| 68 | output |
| 100 | flow chart |
| 102 | phase 1 |
| 104 | phase 2 |
| 110 to | 134 step |
| p | measurement period |
| $\Delta T1(p)$, $\Delta T2(p)$ | average temperature difference |
| $\Delta Tit$ | average temperature difference integration value |
| Ts | temperature step |
| $\Delta Tth$ | average temperature difference threshold |

**Claims**

1. Method for monitoring a particle filter device (30, 52), comprising:

   filtering a fluid,
   using the fluid for cooling,
   detecting (122) at least one temperature value (Ta) of the fluid after the cooling, and
   monitoring (124) the filtering using the at least one temperature value (Ta).

2. Method according to claim 1, comprising:

detecting at least one first temperature value (Tb) of the fluid before the cooling,
the at least one temperature value (Ta) detected after the cooling being at least one second temperature value (Ta), using the at least one first temperature value (Tb) and the at least one second temperature value (Ta) for the monitoring (124).

3. Method according to claim 2, wherein an average temperature difference is used for the monitoring (124) during a measurement period (p).

4. Method according to claim 3, comprising:

   determining (114) a first average temperature difference ($\Delta$T1) during a first measurement period,
   determining (116) a second average temperature difference ($\Delta$T2) during second measurement period,
   using the first average temperature difference ($\Delta$T1) and the second average temperature difference ($\Delta$T2) to verify (118) the length of the measurement period (p) or to decide to change (120) the length of the measurement period (p).

5. Method according to claim 3 or 4, comprising:

   comparing (124) the average temperature difference ($\Delta$T(p)) with at least one threshold value ($\Delta$Tth), and
   creating (126) an error signal if the at least one threshold value ($\Delta$Tth) is not met.

6. Method according to claim 5, comprising:

   using the error signal to trigger an inspection of a filtering device (30, 52) that is used for the filtering.

7. Method according to claim 6, wherein the filtering comprises filtering of air in an electronics shelf (10).

8. Method according to claim 7, wherein the shelf (10) comprises a telecommunications system.

9. Module (10) for housing electronics, comprising:

   a casing (12 to 18),
   at least one air inlet opening (19) in the casing (12 to 18), at least one air outlet opening (20) in the casing (12 to 18),
   a filter device (30) for filtering air that comes through the at least one inlet opening (19),
   a monitoring unit (34) that monitors the functions of the filter device (30) and that is arranged in the module (10) or outside the module (10),
   at least one temperature sensor (Ta, Tb) that is connected to the monitoring unit (34).

10. Module (10) according to claim 9, wherein there are:

    a first temperature sensor (Tb) that is connected to a first input of the monitoring unit (34), and
    a second temperature sensor (Ta) that is connected to a second input of the monitoring unit (34).

11. Module (10) according to claim 9 or 10, comprising:

    at least one fan for creating an airflow (40, 42) between the at least one air inlet opening (19) and the at least one air outlet opening (20).

12. Module (10) according to one of the claims 9 to 11, comprising a back plane (21) having slots for a plurality of electronics circuit boards.

13. Module (10) according to one of the claims 9 to 12, wherein the module (10) is used to perform a method according to one of the claims 1 to 8.

14. A computer program product having computer readable program code portions for performing the method steps according to any of claims 1 to 8.

FIG 1

FIG 2

## FIG 3

100

110 — ( Change air filter )

112 — Set p (=1 day), ΔTth, ΔTit and Ts

114 — Measure ΔT1(p)

120 — p=p+1 (days)

116 — Measure ΔT2(p)

118 — ΔT1(p)-ΔT2(p) >ΔTit?  — Yes

No

122 — Measure ΔT(p)

124 — ΔT(p)>ΔTth?  — No

122

Yes — 126

130 — ΔTth=ΔTth+Ts

126 — Send change filter warning

134 — Change air filter

128 — Filter need to be changed?  — No

Yes — 132 — Reset parameters?  — Yes

No

102 Phase 1

104 Phase 2

**European Patent Office**

**EUROPEAN SEARCH REPORT**

Application Number

EP 08 00 0181

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 6 319 114 B1 (NAIR RAJESH [US] ET AL) 20 November 2001 (2001-11-20) * column 4, line 52 - line 60 * * column 5, line 5 - line 53; figure 1 * ----- | 1-14 | INV. B01D46/00 B01D46/44 G06F1/20 H05K7/20 |
| X | US 2007/144354 A1 (MULLER P KEITH [US] ET AL) 28 June 2007 (2007-06-28) * paragraph [0007] - paragraph [0008]; figure 4 * * paragraph [0018] - paragraph [0021] * * paragraph [0023] * * paragraph [0026] * * paragraph [0028] - paragraph [0029] * * paragraph [0034] - paragraph [0035] * ----- | 1-14 | |
| X | US 6 168 646 B1 (CRAIG WILLIAM L [US] ET AL) 2 January 2001 (2001-01-02) * column 1, line 49 - line 51 * * column 3, line 34 - line 50 * * column 6, line 48 - line 57 * * column 8, line 53 - column 9, line 3 * * column 9, line 16 - line 42 * ----- | 1-14 | |
| A | US 2004/201482 A1 (PEDOEEM ALBERT [US] ET AL) 14 October 2004 (2004-10-14) * the whole document * ----- | 1-14 | TECHNICAL FIELDS SEARCHED (IPC) B01D G06F H05K |
| A | US 6 104 003 A (JONES CLIFFORD T [US]) 15 August 2000 (2000-08-15) * the whole document * ----- | 1-14 | |

The present search report has been drawn up for all claims

| Place of search | Date of completion of the search | Examiner |
|---|---|---|
| The Hague | 17 June 2008 | Baila, Alexandra |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 08 00 0181

This annex lists the patent family members relating to the patent documents cited in the above-mentioned European search report.
The members are as contained in the European Patent Office EDP file on
The European Patent Office is in no way liable for these particulars which are merely given for the purpose of information.

17-06-2008

| Patent document cited in search report | | Publication date | Patent family member(s) | | | Publication date |
|---|---|---|---|---|---|---|
| US 6319114 | B1 | 20-11-2001 | NONE | | | |
| US 2007144354 | A1 | 28-06-2007 | NONE | | | |
| US 6168646 | B1 | 02-01-2001 | NONE | | | |
| US 2004201482 | A1 | 14-10-2004 | NONE | | | |
| US 6104003 | A | 15-08-2000 | AU | 6512099 | A | 01-05-2000 |
| | | | CA | 2347715 | A1 | 20-04-2000 |
| | | | CN | 1323162 | A | 21-11-2001 |
| | | | DE | 19983613 | T5 | 06-05-2004 |
| | | | GB | 2359933 | A | 05-09-2001 |
| | | | WO | 0021372 | A1 | 20-04-2000 |
| | | | US | 6127663 | A | 03-10-2000 |

EPO FORM P0459

For more details about this annex : see Official Journal of the European Patent Office, No. 12/82